(19) **Europäisches Patentamt**
**European Patent Office**
**Office européen des brevets**

(11) **EP 4 693 176 A1**

(12) **EUROPEAN PATENT APPLICATION**
published in accordance with Art. 153(4) EPC

(43) Date of publication:
**11.02.2026 Bulletin 2026/07**

(21) Application number: **24780023.8**

(22) Date of filing: **22.03.2024**

(51) International Patent Classification (IPC):
*G06T 7/00* (2017.01)  *G01N 3/20* (2006.01)

(52) Cooperative Patent Classification (CPC):
**G01N 3/20; G06T 7/00**

(86) International application number:
**PCT/JP2024/011403**

(87) International publication number:
**WO 2024/203905 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **27.03.2023 JP 2023050102**

(71) Applicants:
• **The University of Osaka
Suita-shi, Osaka 565-0871 (JP)**
• **GC R&D Corporation
Tokyo 174-8585 (JP)**

(72) Inventors:
• **YAMAGUCHI, Satoshi
Suita-shi, Osaka 565-0871 (JP)**
• **IMAZATO, Satoshi
Suita-shi, Osaka 565-0871 (JP)**
• **HOKII, Yusuke
Tokyo 174-8585 (JP)**
• **AKIYAMA, Shigenori
Tokyo 174-8585 (JP)**
• **SHINOZAKI, Yutaka
Tokyo 174-8585 (JP)**

(74) Representative: **Müller-Boré & Partner
Patentanwälte PartG mbB
Friedenheimer Brücke 21
80639 München (DE)**

(54) **CONDITION PREDICTION METHOD, PROGRAM, AND DEVICE**

(57) A condition for obtaining a property value of a target material is predicted. A method according to an embodiment of the present invention includes: acquiring a property value of a material; predicting a feature of the material based on the acquired property value of the material by performing an inverse analysis on a model that predicts a property value of the material based on a feature of the material; generating a result of topological data analysis based on the predicted feature of the material; and presenting, on an image of a material different from the material, a pixel corresponding to a portion designated in the result of the topological data analysis.

FIG.8

EP 4 693 176 A1

**Description**

TECHNICAL FIELD

The present invention relates to a condition prediction method, a program, and a device.

BACKGROUND ART

In materials development, a technique of fabricating actual materials and evaluating property values of the materials has been adopted. At present, a technique called materials informatics, which uses machine learning to predict property values of materials, has also been adopted.

CITATION LIST

PATENT LITERATURE

Patent Literature 1: Japanese Patent No. 7188644

SUMMARY OF THE INVENTION

TECHNICAL PROBLEM

However, in materials development, there has been a need to predict a condition for obtaining a property value of a target material. It is an object of the present invention to predict a condition for obtaining a property value of a target material.

SOLUTION TO THE PROBLEM

A method according an embodiment of the present invention includes: acquiring a property value of a material; predicting a feature of the material based on the acquired property value of the material by performing an inverse analysis on a model that predicts a property value of the material based on a feature of the material to; generating a result of topological data analysis based on the predicted feature of the material; and presenting, on an image of a material different from the material, a pixel corresponding to a portion designated in the result of the topological data analysis.

ADVANTAGEOUS EFFECTS OF THE INVENTION

According to the present invention, it is possible to predict a condition for obtaining a property value of a target material.

BRIEF DESCRIPTION OF THE DRAWINGS

[FIG. 1] FIG. 1 is a diagram illustrating an entire configuration according to an embodiment of the present invention.
[FIG. 2] FIG. 2 is a functional block diagram of a forward analysis (property value prediction) device according to an embodiment of the present invention.
[FIG. 3] FIG. 3 is a functional block diagram of a learning device according to an embodiment of the present invention.
[FIG. 4] FIG. 4 is a functional block diagram of an inverse analysis (condition prediction) device according to an embodiment of the present invention.
[FIG. 5] FIG. 5 is a flowchart of a forward analysis (property value prediction) process according to an embodiment of the present invention.
[FIG. 6] FIG. 6 is a flowchart of a learning process according to an embodiment of the present invention.
[FIG. 7] FIG. 7 is a flowchart of an inverse analysis (condition prediction) process according to an embodiment of the present invention.
[FIG. 8] FIG. 8 is an explanatory diagram of correspondence between the forward analysis and the inverse analysis according to an embodiment of the present invention.
[FIG. 9] FIG. 9 is an explanatory diagram of image division according to an embodiment of the present invention.
[FIG. 10] FIG. 10 is an explanatory diagram of image preprocessing according to an embodiment of the present invention.

[FIG. 11] FIG. 11 is an explanatory diagram of topological data analysis (persistent homology) according to an embodiment of the present invention.

[FIG. 12] FIG. 12 is an explanatory diagram of vector dimensionality reduction according to an embodiment of the present invention.

[FIG. 13] FIG. 13 is an explanatory diagram of vector dimensionality reduction according to an embodiment of the present invention.

[FIG. 14] FIG. 14 is an explanatory diagram of machine learning according to an embodiment of the present invention.

[FIG. 15] FIG. 15 is an explanatory diagram of an analysis according to an embodiment of the present invention.

[FIG. 16] FIG. 16 is an explanatory diagram of an analysis according to an embodiment of the present invention.

[FIG. 17] FIG. 17 is an explanatory diagram of an inverse analysis (inverse analysis of a regression model) according to an embodiment of the present invention.

[FIG. 18] FIG. 18 is an explanatory diagram of an inverse analysis (generation of results of topological data analysis) according to an embodiment of the present invention.

[FIG. 19] FIG. 19 is an explanatory diagram of an inverse analysis (presentation, on an image of a different material, of a pixel corresponding to a portion designated in the results of topological data analysis) according to an embodiment of the present invention.

[FIG. 20] FIG. 20 is a hardware configuration diagram of the forward analysis (property value prediction) device, the learning device, and the inverse analysis (condition prediction) device according to an embodiment of the present invention.

DESCRIPTION OF THE EMBODIMENTS

Hereinafter, embodiments of the present invention will be described with reference to the drawings.

<Explanation of Terms>

- As used herein, a "material" may be any material. For example, the "material" is a medical material (e.g., a dental material). For example, the "material" is any one of a ceramic, a glass ceramic, a polymer material, a composite resin, a glass ionomer, or a metal (e.g., a dental ceramic, a dental glass ceramic, a dental polymer material, a dental composite resin, a dental glass ionomer, or a dental metal).
- As used herein, a "property value" may be any property value. For example, the "property value" is a mechanical property (e.g., biaxial flexural strength, abrasion resistance, or the like).

<Entire Configuration>

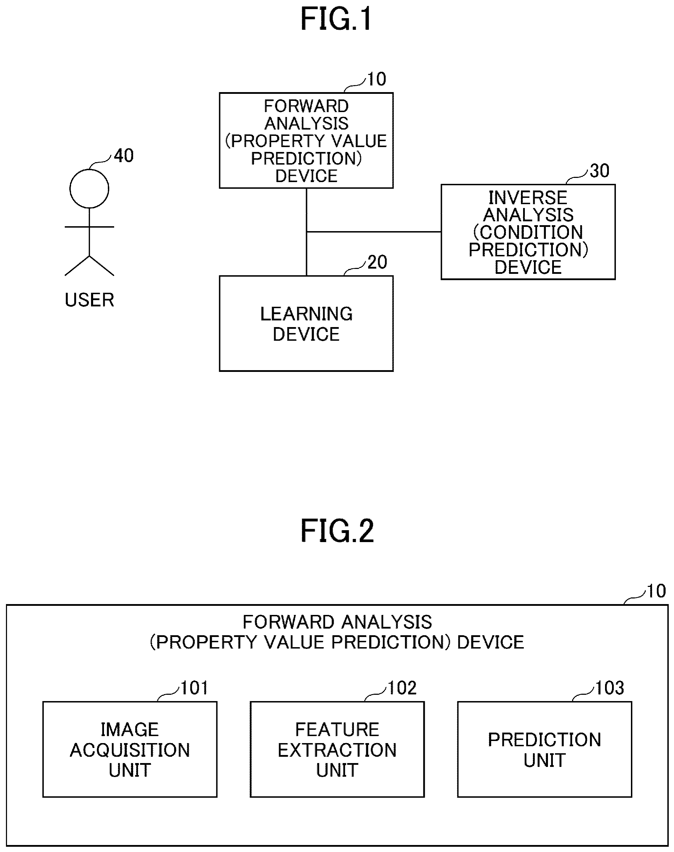

FIG. 1 is a diagram illustrating an entire configuration according to an embodiment of the present invention. A user 40 operates a forward analysis (property value prediction) device 10, a learning device 20, and an inverse analysis (condition prediction) device 30. Although the forward analysis (property value prediction) device 10, the learning device 20, and the inverse analysis (condition prediction) device 30 are described as separate devices in FIG. 1, the forward analysis (property value prediction) device 10, the learning device 20, and the inverse analysis (condition prediction) device 30 may be implemented in one device.

<<Forward Analysis (Property Value Prediction) Device>>

The forward analysis (property value prediction) device 10 is a device configured to predict a property value of a material. The forward analysis (property value prediction) device 10 is constituted by one or a plurality of computers. The forward analysis (property value prediction) device 10 can transmit and receive data to and from the learning device 20 and the inverse analysis (condition prediction) device 30 via any network.

<<Learning Device>>

The learning device 20 is a device configured to generate a trained model used for predicting the property value of the material. The learning device 20 is constituted by one or a plurality of computers. The learning device 20 can transmit and receive data to and from the forward analysis (property value prediction) device 10 and the inverse analysis (condition prediction) device 30 via any network.

<<Inverse Analysis (Condition Prediction) Device>>

The inverse analysis (condition prediction) device 30 is a device configured to predict a condition for obtaining a property value of a target material. The inverse analysis (condition prediction) device 30 is constituted by one or a plurality of computers. The inverse analysis (condition prediction) device 30 can transmit and receive data to and from the forward analysis (property value prediction) device 10 and the learning device 20 via any network.

<Functional Blocks>

Hereinafter, functional blocks of the forward analysis (property value prediction) device 10, the learning device 20, and the inverse analysis (condition prediction) device 30 will be described with reference to FIGS. 2, 3, and 4, respectively.

FIG. 2 is a functional block diagram of the forward analysis (property value prediction) device 10 according to an embodiment of the present invention. The forward analysis (property value prediction) device 10 includes an image acquisition unit 101, a feature extraction unit 102, and a prediction unit 103. Execution of a program allows the forward analysis (property value prediction) device 10 to function as the image acquisition unit 101, the feature extraction unit 102, and the prediction unit 103.

The image acquisition unit (also simply referred to as an acquisition unit) 101 is configured to acquire an image of a material. The image acquisition unit 101 may divide the acquired image and use the divided images. For example, the image is a scanning electron microscope (SEM) image.

The feature extraction unit 102 is configured to extract features of the material by conducting topological data analysis on the image (or the divided images) of the material acquired by the image acquisition unit 101. For example, the topological data analysis involves an analysis using persistent homology. The feature extraction unit 102 may reduce the dimensionality of the extracted features of the material (e.g., principal component analysis).

The prediction unit 103 is configured to predict the property value of the material from the features of the material by using the trained model generated by the learning device 20.

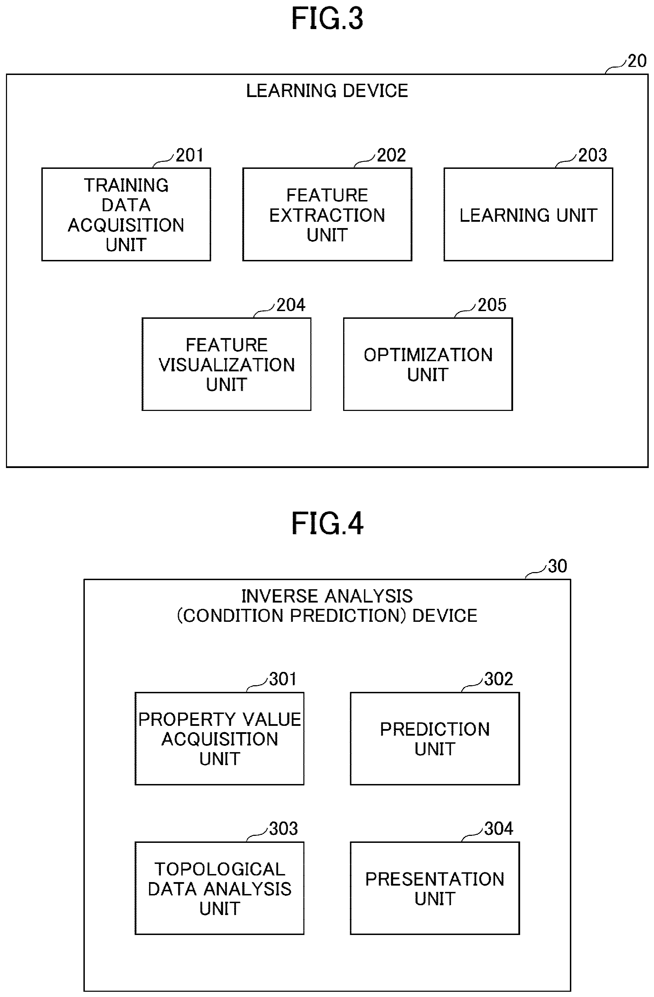

FIG. 3 is a functional block diagram of the learning device 20 according to an embodiment of the present invention. The learning device 20 includes a training data acquisition unit 201, a feature extraction unit 202, a learning unit 203, a feature visualization unit 204, and an optimization unit 205. Execution of a program allows the learning device 20 to function as the training data acquisition unit 201, the feature extraction unit 202, the learning unit 203, the feature visualization unit 204, and the optimization unit 205.

The training data acquisition unit (also simply referred to as an acquisition unit) 201 is configured to acquire training data used for generating a trained model. Specifically, the training data acquisition unit 201 is configured to acquire an image of a material and an actual measurement value of a property value of the material. The training data acquisition unit 201 may divide the acquired image and use the divided images. For example, the image is an SEM image.

The feature extraction unit 202 is configured to extract features of the material by performing topological data analysis on the image (or the divided images) of the material acquired by the training data acquisition unit 201. For example, the topological data analysis involves an analysis using persistent homology. The feature extraction unit 202 may reduce the dimensionality of the extracted features of the material (e.g., principal component analysis).

The learning unit 203 is configured to create a machine learning model by using the features of the materials and the actual measurement values of the property values of the materials, and to generate a trained model for predicting a property value of a material from a feature of the material.

For example, the learning unit 203 trains the model parameters of the Gaussian Mixture Regression (GMR) algorithm using the Expectation-Maximization (EM) algorithm. Gaussian mixture regression is a regression analysis using a Gaussian Mixture Model (GMM).

The feature visualization unit 204 is configured to visualize the features of the materials.

The optimization unit 205 is configured to determine a parameter used for extracting the features of the material by Bayesian optimization.

FIG. 4 is a functional block diagram of the inverse analysis (condition prediction) device 30 according to an embodiment of the present invention. The inverse analysis (condition prediction) device 30 includes a property value acquisition unit 301, a prediction unit 302, a topological data analysis unit 303, and a presentation unit 304. Execution of a program allows the inverse analysis (condition prediction) device 30 to function as the property value acquisition unit 301, the prediction unit 302, the topological data analysis unit 303, and the presentation unit 304.

The property value acquisition unit (also simply referred to as an acquisition unit) 301 is configured to acquire a property value of a material (e.g., a property value of a target material input into the inverse analysis (condition prediction) device 30 by the user 40).

The prediction unit 302 is configured to perform an inverse analysis on a model (e.g., a model generated by the GMR algorithm), which is generated by the learning device 20 and predicts a property value of a material from the features of the material, and to predict a feature of a material from the property value of the material acquired by the property value acquisition unit 301. A parameter of the inverse analysis is a parameter of a model for predicting the property value of the material from the features of the material.

[Gaussian Mixture Regression]

Herein, GMR will be described. As described above, GMR is a regression analysis using the GMM, and is configured to represent a relationship between explanatory variables and objective variables as a superposition of a plurality of normal distributions.

In GMR, in a case of a model for predicting a property value (denoted as y) of a material from the features (denoted as x) of the material, a joint distribution (also referred to as a joint probability distribution) $p(x,y)$ is computed using the GMM, and the conditional probability distribution $p(y|x)$ is computed from $p(x,y)$ using Bayes' theorem. That is, the probability distribution of the property value of the material is predicted.

Meanwhile, in the inverse analysis (i.e., in a case of predicting a feature (x) of a material from the property value (y) of the material), a joint distribution (also referred to as a joint probability distribution) $p(y,x)$ is computed using the GMM, and the conditional probability distribution $p(x|y)$ is computed from $p(y,x)$ using Bayes' theorem. That is, the probability distribution of the feature of the material is predicted.

The topological data analysis unit 303 is configured to generate the results of the topological data analysis based on the features of the material predicted by the prediction unit 302. For example, the topological data analysis unit 303 generates persistence diagrams by persistent homology analysis based on the feature of the material predicted by the prediction unit 302.

The topological data analysis unit 303 may generate the results of the topological data analysis after conducting an inverse transform of the dimensionality reduction (e.g., inverse transform of principal component analysis) on the feature of the material predicted by the prediction unit 302.

The presentation unit 304 presents, on an image of a material (e.g., an existing material) different from the material, a pixel corresponding to a portion (e.g., a portion designated by the user 40) designated in the results of the topological data analysis generated by the topological data analysis unit 303. For example, the image is an SEM image.

<Processing Method>

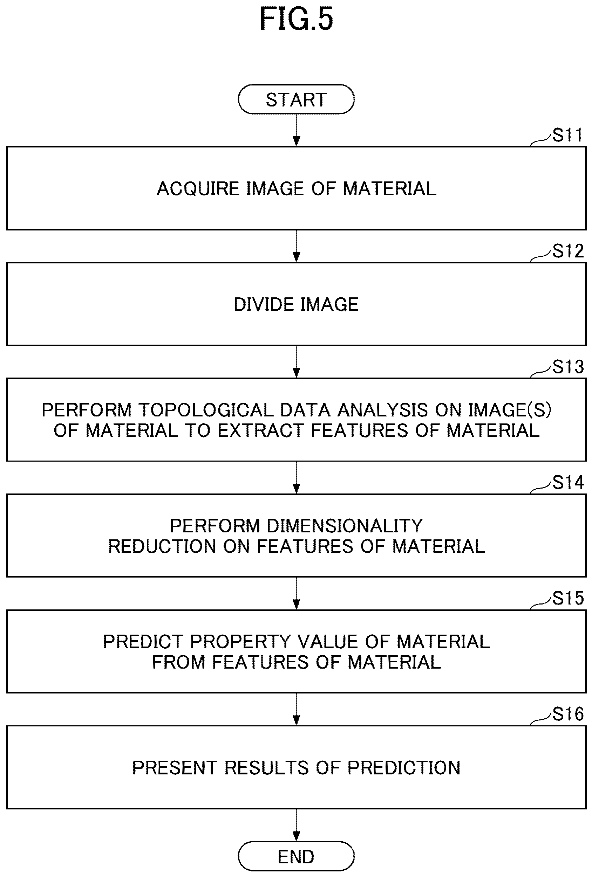

Hereinafter, a forward analysis (property value prediction) process, a learning process, and an inverse analysis (condition prediction) process will be described with reference to FIGS. 5, 6, and 7, respectively.

FIG. 5 is a flowchart of the forward analysis (property value prediction) process according to an embodiment of the present invention.

In Step 11 (S11), the image acquisition unit 101 of the forward analysis (property value prediction) device 10 acquires an image of a material.

In Step 12 (S12), the image acquisition unit 101 of the forward analysis (property value prediction) device 10 divides the image acquired in S11. S12 may be omitted.

In Step 13 (S13), the feature extraction unit 102 of the forward analysis (property value prediction) device 10 extracts features of the material by conducting topological data analysis on the image of the material acquired in S11 or on the divided images in S12.

In Step 14 (S14), the feature extraction unit 102 of the forward analysis (property value prediction) device 10 reduces the dimensionality of the features of the material extracted in S13 (e.g., principal component analysis). S14 may be omitted.

In Step 15 (S15), the prediction unit 103 of the forward analysis (property value prediction) device 10 uses the trained model generated by the learning device 20 to predict a property value of the material from the features of the material extracted in S13 or from the features of the material after the dimensionality reduction in S14.

In Step 16 (S16), the prediction unit 103 of the forward analysis (property value prediction) device 10 presents the results of the prediction in S15 to the user 40 (e.g., displays the results on a screen).

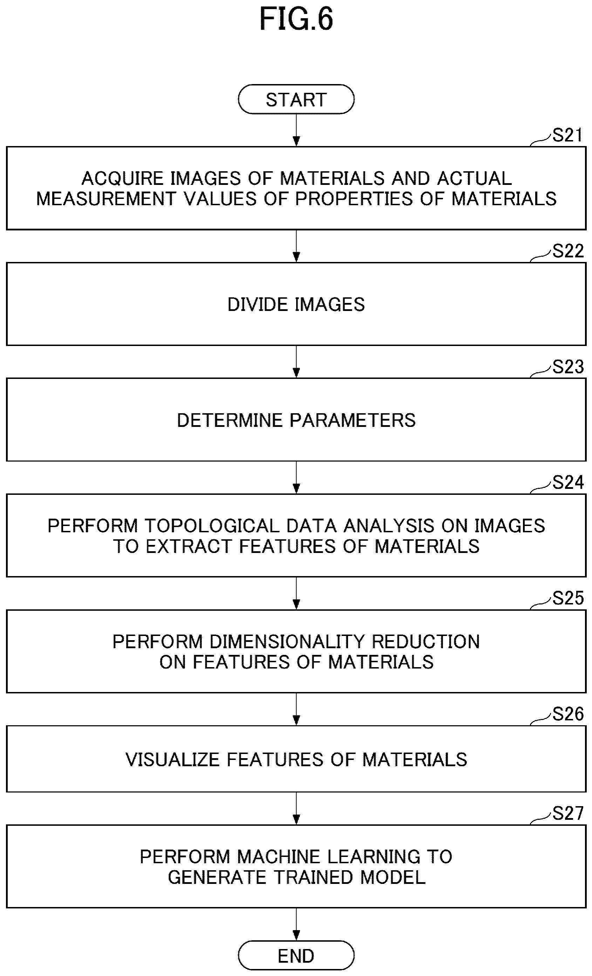

FIG. 6 is a flowchart of the learning process according to an embodiment of the present invention.

In Step 21 (S21), the training data acquisition unit 201 of the learning device 20 acquires training data used for generating a trained model. Specifically, the training data acquisition unit 201 acquires the images of the materials and actual measurement values of the property values of the materials.

In Step 22 (S22), the training data acquisition unit 201 of the learning device 20 divides the images acquired in S21. S22 may be omitted.

In Step 23 (S23), the optimization unit 205 of the learning device 20 determines parameters used for extracting the features of the materials. For example, the optimization unit 205 of the learning device 20 determines parameters used for extracting the features of the materials through Bayesian optimization.

In Step 24 (S24), the feature extraction unit 202 of the learning device 20 extracts the features of the materials by conducting topological data analysis on the images of the materials acquired in S21 or on the divided images in S22.

In Step 25 (S25), the feature extraction unit 202 of the learning device 20 reduces the dimensionality of the features of the materials extracted in S24 (e.g., principal component analysis). S25 may be omitted.

In Step 26 (S26), the feature visualization unit 204 of the learning device 20 visualizes the features of the materials.

In Step 27 (S27), the learning unit 203 of the learning device 20 performs machine learning using the features of the materials and the actual measurement values of the property values of the materials to generate a trained model for predicting the property values of the materials from the features of the materials.

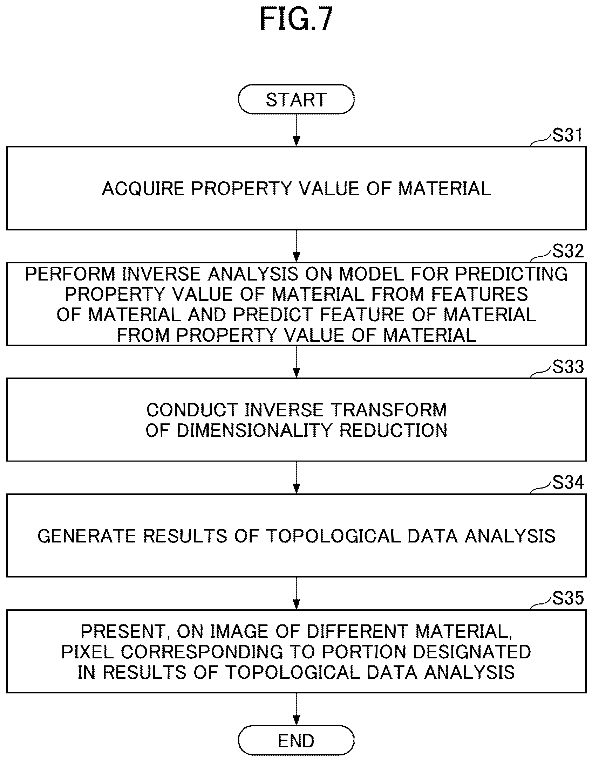

FIG. 7 is a flowchart of the inverse analysis (condition prediction) process according to an embodiment of the present invention.

In Step 31 (S31), the property value acquisition unit 301 of the inverse analysis (condition prediction) device 30 acquires a property value of a material.

In Step 32 (S32), the prediction unit 302 of the inverse analysis (condition prediction) device 30 performs an inverse analysis on the model for predicting the property value of the material from the features of the material, and predicts a feature of the material from the property value of the material acquired in S31.

In Step 33 (S33), the topological data analysis unit 303 of the inverse analysis (condition prediction) device 30 conducts an inverse transform of the dimensionality reduction (e.g., inverse transform of principal component analysis) on the features of the material predicted in S32. S33 may be omitted.

In Step 34 (S34), the topological data analysis unit 303 of the inverse analysis (condition prediction) device 30 generates results of the topological data analysis based on the features of the material predicted in S32 or on the features of the material after the inverse transform of the dimensionality reduction in S33.

In Step 35 (S35), the presentation unit 304 of the inverse analysis (condition prediction) device 30 presents, on the image of the different material, a pixel corresponding to a portion designated in the results of the topological data analysis generated in S34.

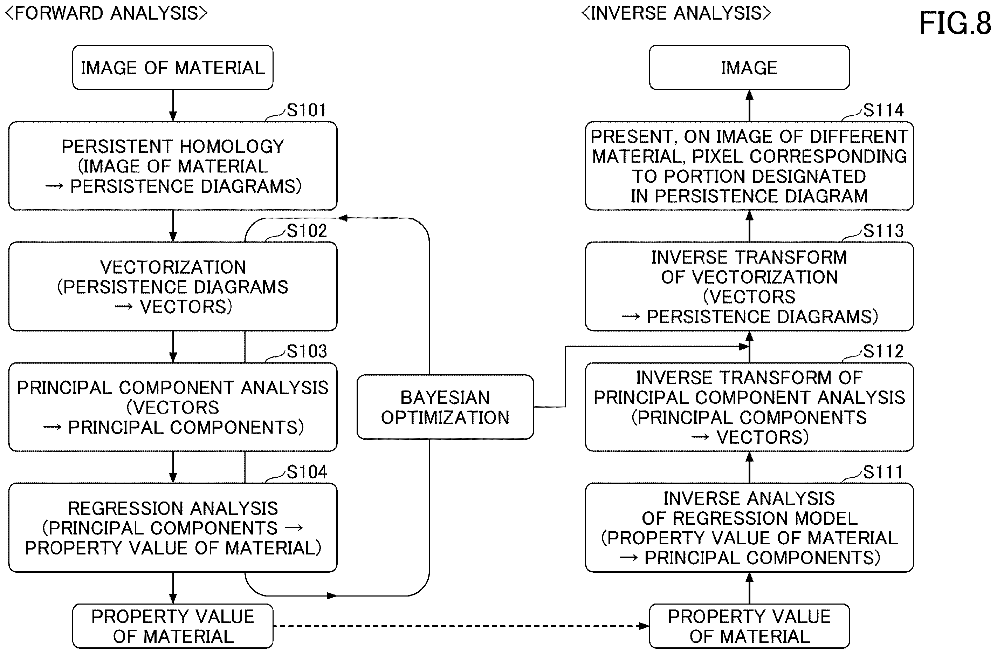

FIG. 8 is an explanatory diagram of correspondence between the forward analysis and the inverse analysis according to an embodiment of the present invention.

<Forward Analysis>

The forward analysis will be described.

First, in Step 101 (S101), topological data analysis is conducted on the image of the material. Specifically, topological data analysis is performed on images of materials by using persistent homology to generate persistence diagrams.

Next, in Step 102 (S102), features are extracted from the results of the topological data analysis of the images of the materials. Specifically, the persistence diagrams are vectorized.

Next, in Step 103 (S103), dimensionality reduction is conducted on the features. Specifically, principal component analysis is conducted on the features (vectors) to create principal components.

Next, in Step 104 (S104), regression analysis is conducted. Specifically, the principal components are input into the model generated by the GMR algorithm, and the property value of the material is output.

<Inverse Analysis>

The inverse analysis will be described.

First, in Step 111 (S111), inverse analysis is conducted on the regression model. Specifically, an inverse analysis is conducted on a model (a model in S104 in which a property value of a material is output in response to input of the principal components) generated by the GMR algorithm, and the principal components are output in response to input of a property value of the material. In the inverse analysis of Step 111, a parameter used in the regression analysis of Step 104 is used.

Next, in Step 112 (S112), an inverse transform of dimensionality reduction is conducted. Specifically, an inverse transform of principal component analysis (principal component analysis of the features (vectors) in S103) is conducted, and the features (vectors) are generated from the principal components. In the inverse transform of Step 112, the parameter used in the principal component analysis of Step 103 is used.

Next, in Step 113 (S113), an inverse transform of the extraction of the features (vectors) of the material is conducted. Specifically, the inverse transform of the vectorization (vectorization of the persistence diagrams in S102) is conducted to generate the persistence diagrams from the features (vectors) of the material. In the inverse transform of Step 113, a parameter used in the vectorization of Step 102 is used.

Next, in Step 114 (S114), a pixel corresponding to a portion designated in the results of the topological data analysis (e.g., persistence diagrams) is presented on an image of a different material.

Hereinafter, each process will be described in detail. As an example, a case in which a dental glass ceramic is used will be described. The glass ceramic may be subjected to alkaline etching (i.e., the glassy substance is dissolved) to expose crystal grains, or may be unprocessed. Alternatively, an ion milling may be applied.

<<Image Division>>

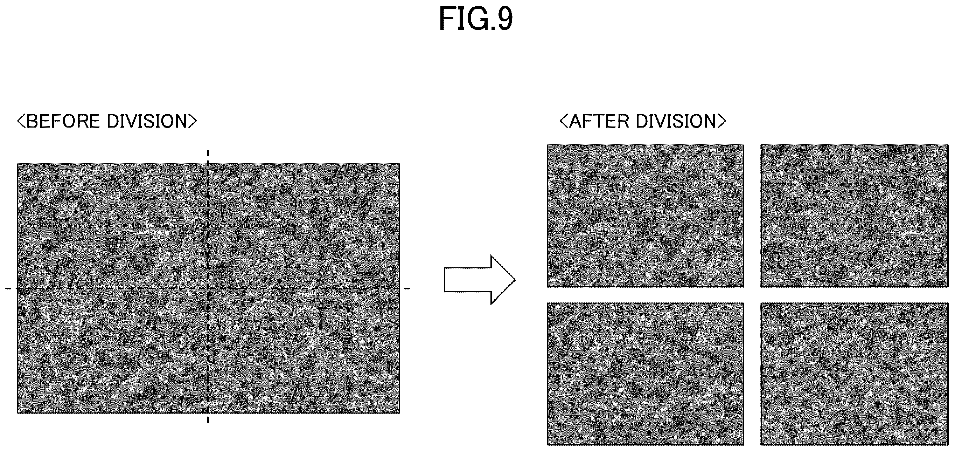

First, the forward analysis (property value prediction) device 10 and the learning device 20 divide an SEM image. FIG. 9 is an explanatory diagram of image division according to an embodiment of the present invention. FIG. 9 shows an SEM image before the division on the left and the SEM images after the division on the right.

As shown in <BEFORE DIVISION> on the left in FIG. 9, an unnecessary portion is removed if present in the SEM image. Then, the SEM image is divided (divided into four in the example of FIG. 9).

As shown in <AFTER DIVISION> on the right in FIG. 9, one SEM image is divided into a plurality of images. Excessive division causes loss of information included in the image, leading to inaccurate prediction. Therefore, the image is preferably divided into two to four. Such image division can increase training data for machine learning. In addition, by dividing the image, any inhomogeneities in one image of a material can be extracted using principal component analysis.

<<Image Preprocessing>>

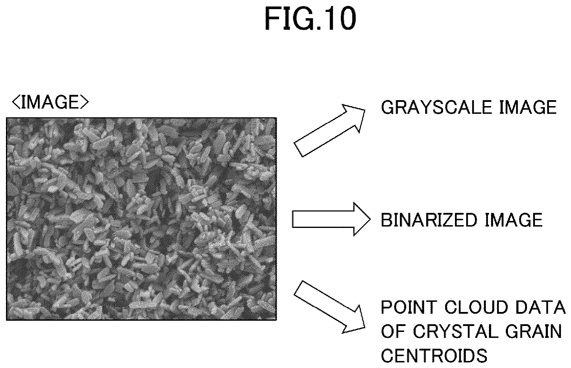

Next, the forward analysis (property value prediction) device 10 and the learning device 20 preprocess the image. FIG. 10 is an explanatory diagram of image preprocessing according to an embodiment of the present invention.

In the present invention, a grayscale image may be used (i.e., an original SEM image may be used), or a binarized image may be used (in this case, an SEM image is binarized as preprocessing). Instead of the grayscale image or the binarized image, point cloud data indicating the crystal grain centroids included in the image may be used (in this case, the crystal grain centroids included in the image are extracted to generate point cloud data as preprocessing).

<<Topological Data Analysis (Persistent Homology)>>

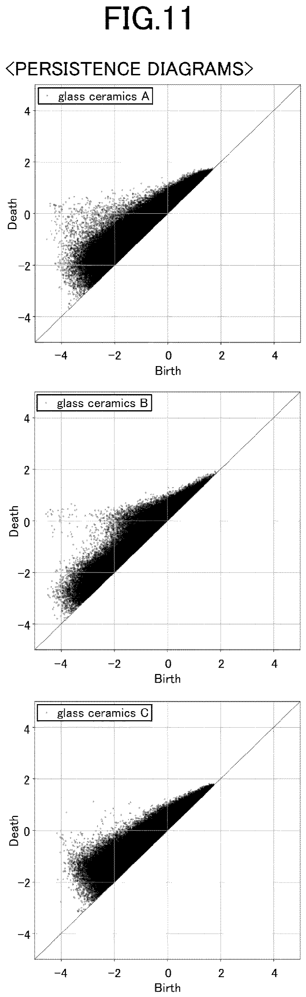

Next, the forward analysis (property value prediction) device 10 and the learning device 20 perform topological data analysis (persistent homology) on the image. FIG. 11 is an explanatory diagram of topological data analysis (persistent homology) according to an embodiment of the present invention.

In an embodiment of the present invention, persistent homology is calculated for each SEM image to obtain an nth-order persistence diagram (e.g., a 0th-order persistence diagram and a 1st-order persistence diagram).

Herein, persistent homology will be described. Persistent homology is a type of data analysis incorporating the concept of mathematical topology (topological data analysis), and quantitatively shows information on the shape of data based on the structure of connected components, holes, voids, or the like of a figure. Persistence diagrams show the birth and death of topological features such as connected components, holes, and voids, or the like of a figure. The 0th-order persistent homology calculates the connection between points, and the 1st-order persistent homology calculates the relationships of loops formed by clusters of points. Thus, by using persistent homology, it is possible to find the topological features of the image of the material.

<<Extraction of Features (Vectorization)>>

Next, the forward analysis (property value prediction) device 10 and the learning device 20 extract (vectorize) the features from the persistence diagrams. Specifically, a persistence image (PI) technique (e.g., "Basics of Persistent Homology and Application Examples to Materials Engineering" (https://www.jim.or.jp/journal/m/pdf3/58/01/17.pdf)) is used. The persistence diagrams are sectioned into a grid pattern, and the frequency (density) of data points in each section serves as each element of vectors. The frequency (density) follows a normal distribution.

A distribution function $\rho$ is expressed by Equation (1). Dk(X) is a k-th order persistence diagram of X. b is birth (i.e., appearance of a connected component, a hole, a void, or the like of a figure). d is death (i.e., disappearance of the connected component, the hole, the void, or the like of the figure).

According to Equation (2), a numerical value is weighted in accordance with the distance from the diagonal in the persistence diagram (using an arctangent function). In this way, the importance of each point in the persistence diagram can be reflected, with points farther from the diagonal in the persistence diagram considered more important.

Alternatively, the distance from the diagonal may be calculated using an unweighted Euclidean distance.

To calculate the distance from the diagonal, it is required to determine in advance by a human whether to use the Euclidean distance or apply weighting based on the arctangent function. Moreover, it is also required to determine in advance by a human $\sigma$ (standard deviation), C, and p, which are parameters. As described later, to calculate the distance from the diagonal, Bayesian optimization may be used to determine whether to use the Euclidean distance or apply weighting based on the arctangent function. Moreover, Bayesian optimization may also be used to determine the parameters ($\sigma$ (standard deviation), C, p) used for the feature extraction of the material.

[Math. 1]

$$\rho(x,y) = \sum_{(b_i,d_i) \in D_k(X)} w(b_i, d_i) exp\left(-\frac{(x-b_i)^2 + (y-d_i)^2}{2\sigma}\right)$$

$$\cdots \text{EQUATION (1)}$$

[Math. 2]

$$w(b,d) = arctan(C(d-b)^p) \qquad \cdots \text{EQUATION (2)}$$

<<Vector Dimensionality Reduction>>

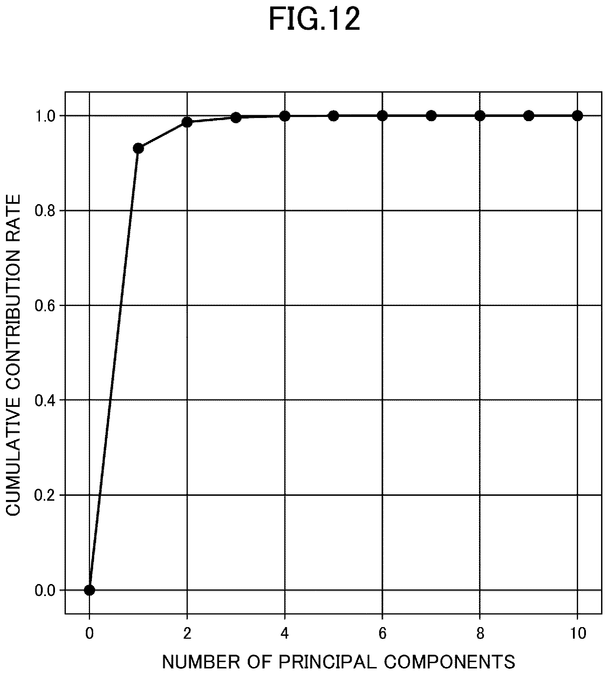

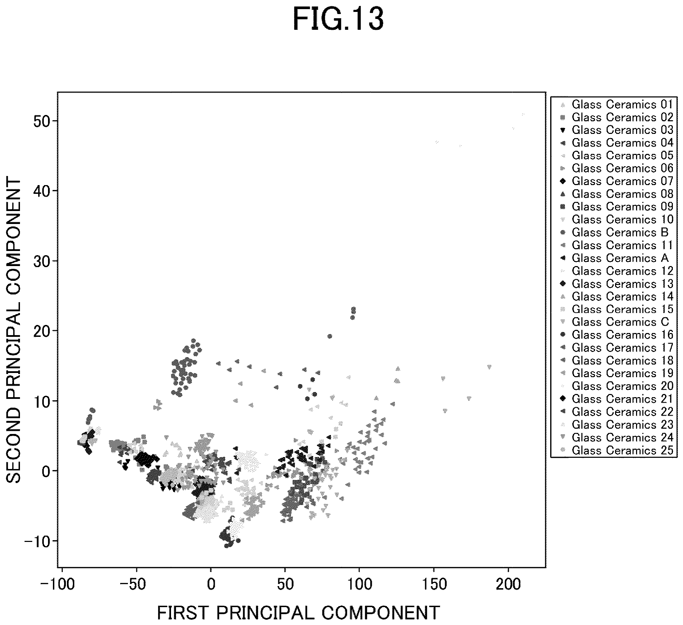

Next, the forward analysis (property value prediction) device 10 and the learning device 20 perform dimensionality reduction of the features (vectors). FIGS. 12 and 13 are explanatory diagrams of vector dimensionality reduction according to an embodiment of the present invention. As a result of extracting (vectorizing) the features from the persistence diagrams to transform one SEM image into vectors having n elements, the entire data is constructed by a very large matrix of "the number of elements of the vectors" $\times$ "the number of SEM images." In this state, it is not possible to perform confirmation of the features by visualization or highly accurate prediction by machine learning. Thus, dimensionality reduction of the features (vectors) was performed using principal component analysis.

FIG. 12 shows a cumulative contribution rate. The vertical axis represents the cumulative contribution rate, and the horizontal axis represents the number of principal components. As a result of the dimensionality reduction of the features (vectors), it was confirmed that the first two principal components could explain approximately 100% of the original data.

In FIG. 13, the data was visualized using the first principal component (horizontal axis) and the second principal component (vertical axis). It was confirmed that each prototype/product formed a cluster which is present in a slightly different region on the graph, and information specific to each material could be taken out. The feature visualization unit 204 visualizes the features of the materials by showing the distribution of each material as in FIG. 13.

<<Machine Learning>>

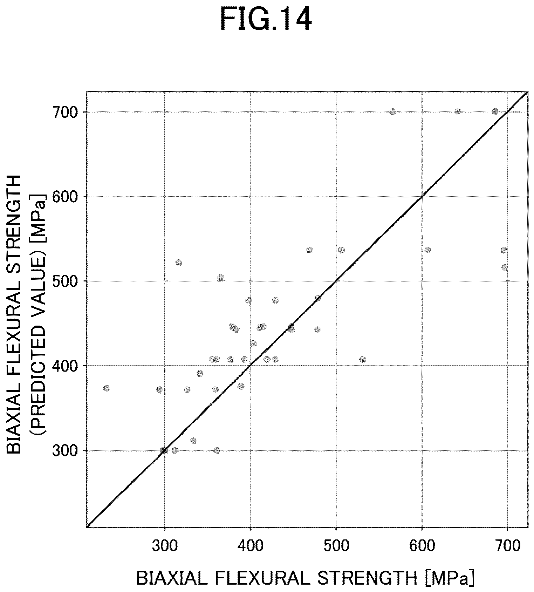

Next, the learning device 20 performs machine learning using the features (vectors). FIG. 14 is an explanatory diagram of machine learning according to an embodiment of the present invention.

FIG. 14 shows the results of extracting the vectors from the persistence diagrams, performing dimensionality reduction using principal component analysis, and performing regression analysis using the GMR algorithm with the biaxial flexural strength serving as the objective variable. In FIG. 14, a 1st-order persistence diagram was used based on the binarized image. The vertical axis in FIG. 14 represents a predicted value (MPa), and the horizontal axis in FIG. 14 represents an actual measurement value (MPa).

Hyperparameters of a machine learning model may be adjusted by any optimization algorithm, such as, for example, grid search, random search, Bayesian optimization, or genetic algorithm.

<<Bayesian Optimization>>

As described above, the learning device 20 can determine whether to use the Euclidean distance or to weight with the arctangent function for the calculation of the distance from the diagonal described above through Bayesian optimization. Moreover, when the arctangent function is selected, the learning device 20 can determine the parameters ($\sigma$ (standard deviation), C, and p in Equation (1) and Equation (2)) used for extracting the features of the materials through Bayesian optimization. Furthermore, the learning device 20 can determine the number of principal components, which is a parameter used for extracting the features of the materials, through Bayesian optimization. After about 50 trials, the combination of the optimum values was found.

Specifically, an acquisition function is computed by computing predicted values of the property values and the variation of the predicted values from the features of the materials using a Gaussian process regression model. Based on this acquisition function, the optimal parameter is determined. By using a Bayesian optimization algorithm together in this way, a human only needs to create and input training data so that the learning device 20 can automatically perform machine learning to generate a trained model.

<<Analysis>>

Various analyses can be performed using the persistence diagrams and the results of principal component analysis described above.

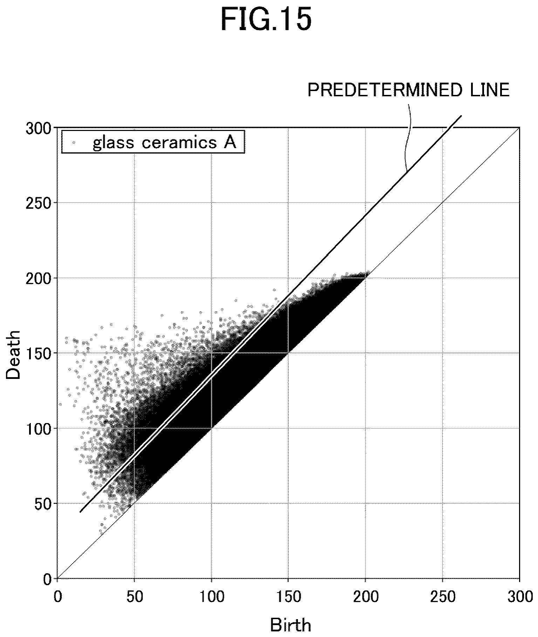

For example, as shown in FIG. 15, a point having a lifetime (i.e., a period from birth to death) longer than a certain period on the persistence diagram (e.g., a portion on the upper left of a predetermined line in FIG. 15) is assumed to be an important point on the image. Therefore, an important structure of the crystal can be found by analyzing which structure of the crystal corresponds to a point having a longer lifetime than a certain period (e.g., a portion on the upper left of the predetermined line in FIG. 15).

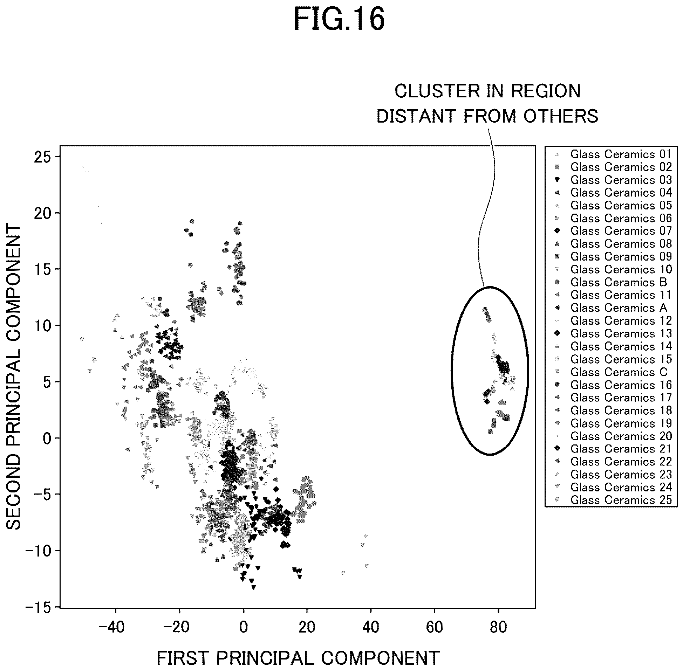

For example, as shown in FIG. 16, it is possible to analyze what kind of crystal structure gives rise to points forming a small cluster in a region distant from others.

Hereinafter, inverse analysis (i.e., prediction of a condition for obtaining a property value of a target material) will be described in detail.

<<Inverse Analysis of Regression Model>>

First, the prediction unit 302 of the inverse analysis (condition prediction) device 30 performs an inverse analysis on a model for predicting a property value of the material from the features of the material (e.g., a model generated by the GMR algorithm), and predicts a feature (principal component) of the material from the property value of the material.

In the inverse analysis (i.e., in the case of predicting the features (x) of the material from the property value (y) of the material), a joint distribution (also referred to as a joint probability distribution) $p(y,x)$ is computed using a GMM, and a conditional probability distribution $p(x|y)$ is computed from $p(y,x)$ using Bayes' theorem. That is, the probability distribution of the features of the material is predicted.

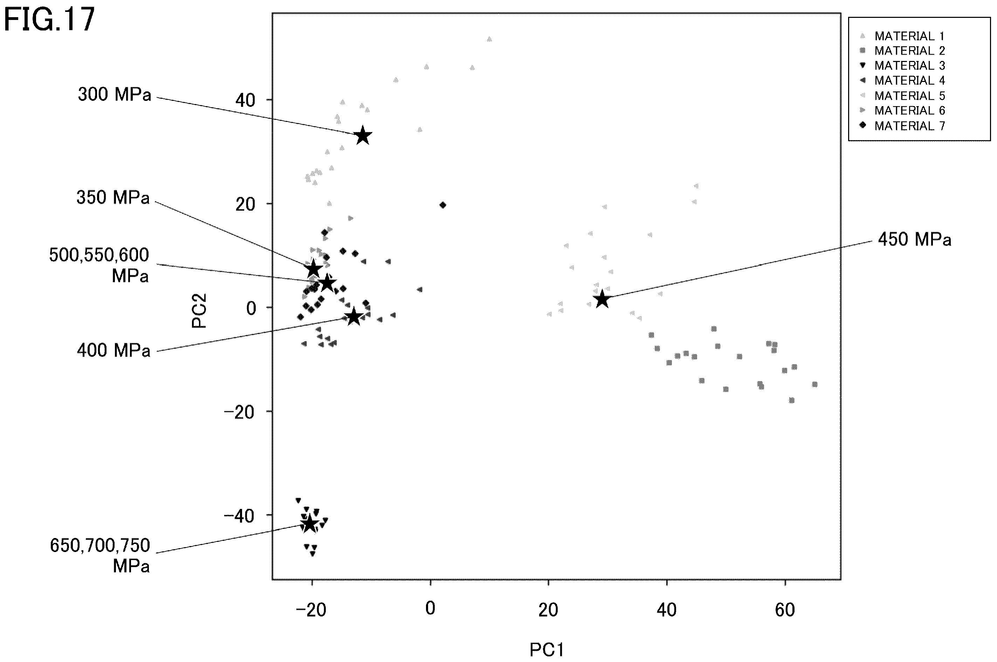

FIG. 17 is an explanatory diagram of the inverse analysis (inverse analysis of the regression model) according to an embodiment of the present invention. FIG. 17 shows the results of predicting the features (principal components) of the materials from the property values of the materials by performing an inverse analysis on the regression model. Stars (★) indicate a weighted average (weighted mean) of the scores of the features (principal components) predicted when the biaxial flexure strength (an example of a property value of a material) is 300 MPa, 350 MPa, 400 MPa, 450 MPa, 500 MPa, 550 MPa, 600 MPa, 650 MPa, 700 MPa, or 750 MPa. Each of the marks of Material 1 to Material 7 indicates an actual value of the score of the feature (principal component) of Material 1 to Material 7.

<<Inverse Transform of Principal Component Analysis>>

Next, the topological data analysis unit 303 of the inverse analysis (condition prediction) device 30 conducts an inverse transform of dimensionality reduction (e.g., inverse transform of principal component analysis) of the features (principal components) of the material predicted by the prediction unit 302, and generates a feature (vector) from the feature (principal component).

<<Inverse Transform of Vectorization>>

Next, the topological data analysis unit 303 of the inverse analysis (condition prediction) device 30 generates the results of the topological data analysis (e.g., persistence diagrams of persistent homology) based on the features (vectors after the inverse transform of dimensionality reduction) of the materials predicted by the prediction unit 302.

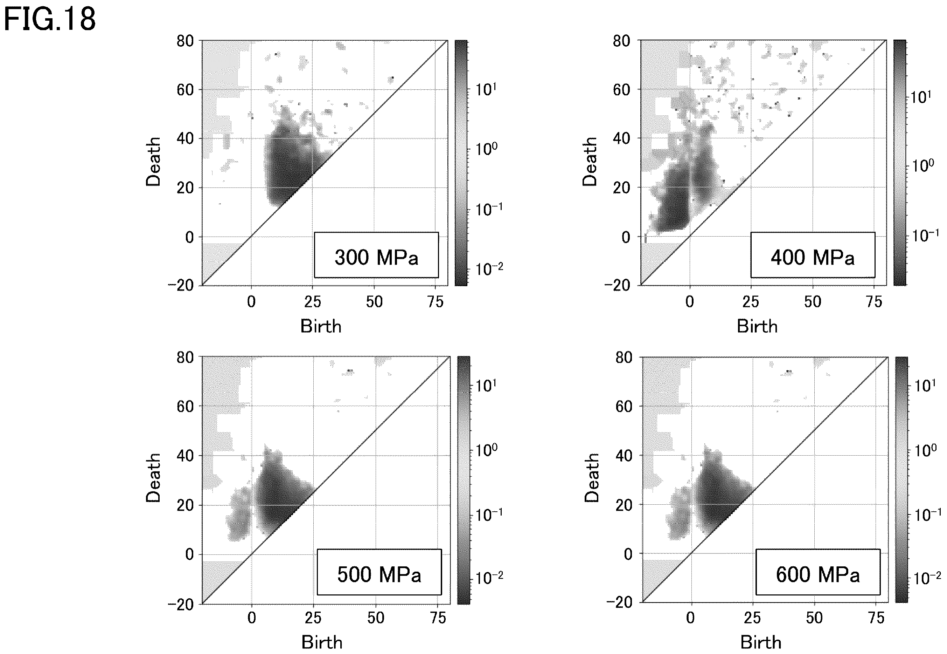

FIG. 18 is an explanatory diagram of inverse analysis (generation of the results of the topological data analysis) according to an embodiment of the present invention. FIG. 18 shows persistence diagrams in a case in which the biaxial flexure strength (an example of a property value of a material) is 300 MPa, 400 MPa, 500 MPa, or 600 MPa.

<<Presentation of Pixel Corresponding to Portion Designated in Results of Topological Data Analysis>>

Next, the presentation unit 304 of the inverse analysis (condition prediction) device 30 presents, on an image of a material (e.g., an existing material) different from the material, a pixel corresponding to a portion (e.g., a portion designated by the user 40) designated in the results of the topological data analysis generated by the topological data analysis unit 303.

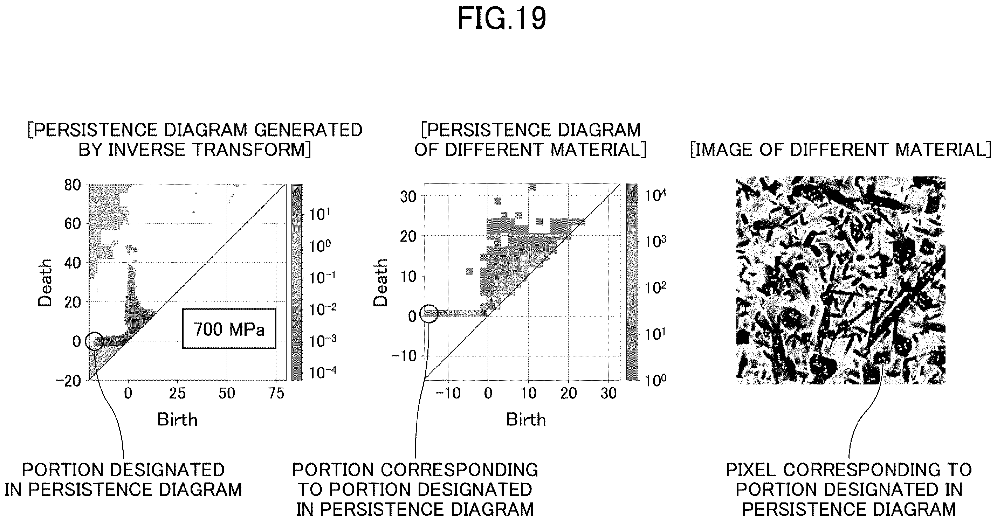

FIG. 19 is an explanatory diagram of inverse analysis (presentation of a pixel corresponding to a portion designated in the results of the topological data analysis on an image of a different material) according to an embodiment of the present invention.

The "PERSISTENCE DIAGRAM GENERATED BY INVERSE TRANSFORM" in FIG. 19 is a persistence diagram generated by the topological data analysis unit 303 of the inverse analysis (condition prediction) device 30. The user 40 designates a desired portion in the persistence diagram displayed on the inverse analysis (condition prediction) device 30. For example, the user can designate a portion in the persistence diagram specific to a material with high strength by designating a portion of a pair of birth and death occurring only in the persistence diagram of 700 MPa (i.e., a portion different from other persistence diagrams of 300 MPa, 400 MPa, 500 MPa, and 600 MPa).

The "PERSISTENCE DIAGRAM OF DIFFERENT MATERIAL" in FIG. 19 is a persistence diagram of a different material (e.g., an existing material designated by the user 40). The presentation unit 304 of the inverse analysis (condition prediction) device 30 identifies a portion in the [PERSISTENCE DIAGRAM OF DIFFERENT MATERIAL] corresponding to the portion designated in the [PERSISTENCE DIAGRAM GENERATED BY INVERSE TRANSFORM].

The "IMAGE OF DIFFERENT MATERIAL" in FIG. 19 is an image of a different material (e.g., an existing material designated by the user 40). The presentation unit 304 of the inverse analysis (condition prediction) device 30 clearly indicates, on the image of the different material, a pixel of a portion in the [PERSISTENCE DIAGRAM OF DIFFERENT MATERIAL] corresponding to the portion designated in the [PERSISTENCE DIAGRAM GENERATED BY INVERSE TRANSFORM] (e.g., the pixel is displayed in a color different from that of other pixels in the image). For example, a pixel corresponding to appearance (birth) of a connected component, a hole, a void, or the like of a figure of the persistence diagrams and a pixel corresponding to disappearance (death) can be clearly indicated separately (e.g., clearly indicated in different colors, clearly indicated with different marks, or the like). For example, only the pixel corresponding to appearance (birth) may be displayed, or only the pixel corresponding to disappearance (death) may be displayed, in accordance with an instruction from the user 40. Not only one image of a different material but also a plurality of images of different materials may be used.

Subsequently, the user 40 can identify a structure assumed to be related to appearance of a property value of high strength or the like by confirming the correspondence with the image of the different material and the structure of the different material.

<Effects>

As described above, in an embodiment of the present invention, the user 40 can easily recognize the structure, composition, manufacturing conditions, and the like of the material for realizing the property value of the target material through inverse analysis.

<Hardware Configuration>

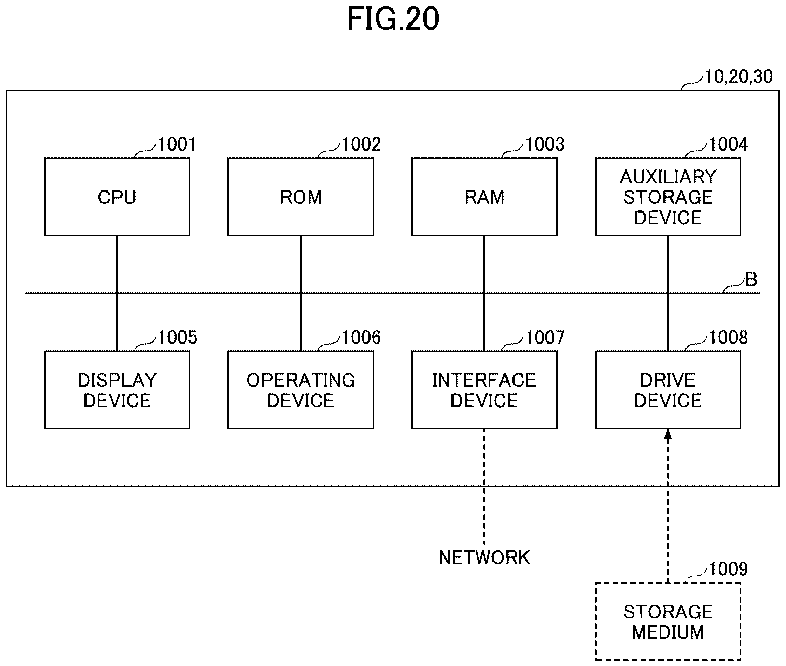

FIG. 20 is a diagram illustrating a hardware configuration of the forward analysis (property value prediction) device 10, the learning device 20, and the inverse analysis (condition prediction) device 30 according to an embodiment of the present invention. The forward analysis (property value prediction) device 10, the learning device 20, and the inverse analysis (condition prediction) device 30 each include a central processing unit (CPU) 1001, a read-only memory (ROM) 1002, and a random-access memory (RAM) 1003. The CPU 1001, the ROM 1002, and the RAM 1003 constitute a so-called computer. The forward analysis (property value prediction) device 10, the learning device 20, and the inverse analysis (condition prediction) device 30 may additionally include an auxiliary storage device 1004, a display device 1005, an operating device 1006, an interface device 1007, and a drive device 1008. The forward analysis (property value prediction) device 10, the learning device 20, and the inverse analysis (condition prediction) device 30 are interconnected via a bus B at the hardware-level. The forward analysis (property value prediction) device 10, the learning device 20, and the inverse analysis (condition prediction) device 30 may include a graphics processing unit (GPU).

The CPU 1001 is a computing device configured to execute various programs installed in the auxiliary storage device 1004. The CPU 1001 executes a program to perform each process described herein.

The ROM 1002 is a nonvolatile memory. The ROM 1002 functions as a main storage device configured to store various programs, data, and the like necessary for 1001 to execute various programs installed in the auxiliary storage device 1004. Specifically, the ROM 1002 functions as a main storage device configured to store boot programs and the like for a basic input/output system (BIOS), an extensible firmware interface (EFI), and the like.

The RAM 1003 is a volatile memory such as a dynamic random-access memory (DRAM), a static random-access memory (SRAM), or the like. The RAM 1003 functions as a main storage device configured to provide a work area where various programs installed in the auxiliary storage device 1004 are loaded and expanded for execution by the CPU 1001.

The auxiliary storage device 1004 is an auxiliary storage device configured to store various programs and information used for executing the various programs.

The display device 1005 is a display device configured to display the internal states and the like of the forward analysis (property value prediction) device 10, the learning device 20, and the inverse analysis (condition prediction) device 30.

The operating device 1006 is an input device configured for an operator of the forward analysis (property value prediction) device 10, the learning device 20, and the inverse analysis (condition prediction) device 30 to input various instructions to the forward analysis (property value prediction) device 10, the learning device 20, and the inverse analysis (condition prediction) device 30.

The interface device 1007 is a communication device configured to be connected to a network to communicate with other devices.

The drive device 1008 is a device configured to hold and interface with a storage medium 1009. Examples of the storage medium 1009 herein include a medium that optically, electrically, or magnetically records information, such as a compact disk (CD)-ROM, a flexible disk, a magneto-optical disk, and the like. Examples of the storage medium 1009 may include a semiconductor memory and the like configured to electrically record information, such as a ROM, a flash memory, and the like.

For example, the various programs installed in the auxiliary storage device 1004 are installed as follows: the drive device 1008 holds and interfaces with the distributed storage medium 1009; and the drive device 1008 reads the various programs recorded in the storage medium 1009. Alternatively, the various programs installed in the auxiliary storage device 1004 may be installed by being downloaded from a network via the interface device 1007.

Although examples of the present invention have been described in detail above, the present invention is not limited to the specific embodiments described above, and various modifications and changes can be made within the scope of the gist of the present invention described in the claims.

This international application claims priority based on Japanese Patent Application No. 2023-050102 filed on March 27, 2023, and the entire contents of Japanese Patent Application No. 2023-050102 are incorporated herein by reference.

[Reference Signs List]

| 10 | Forward analysis (property value prediction) device |
|---|---|
| 20 | Learning device |
| 30 | Inverse analysis (condition prediction) device |
| 40 | User |
| 101 | Image acquisition unit |
| 102 | Feature extraction unit |
| 103 | Prediction unit |
| 201 | Training data acquisition unit |
| 202 | Feature extraction unit |
| 203 | Learning unit |
| 204 | Feature visualization unit |
| 205 | Optimization unit |
| 301 | Property value acquisition unit |
| 302 | Prediction unit |
| 303 | Topological data analysis unit |
| 304 | Presentation unit |
| 1001 | CPU |
| 1002 | ROM |
| 1003 | RAM |
| 1004 | Auxiliary storage device |
| 1005 | Display device |
| 1006 | Operating device |
| 1007 | Interface device |
| 1008 | Drive device |
| 1009 | Storage medium |

**Claims**

**1.** A method, comprising:

acquiring a property value of a material;

predicting a feature of the material based on the acquired property value of the material by performing an inverse analysis on a model that predicts a property value of the material based on a feature of the material; generating a result of topological data analysis based on the predicted feature of the material; and presenting, on an image of a material different from the material of the acquired property value, a pixel corresponding to a portion designated in the result of the topological data analysis.

2. The method according to claim 1, wherein
   the inverse analysis is an inverse analysis using Gaussian mixture regression.

3. The method according to claim 1, wherein
   a parameter of the inverse analysis is a parameter of a model for predicting the property value of the material from the feature of the material.

4. The method according to claim 1, wherein
   the result of the topological data analysis is a persistence diagram.

5. The method according to any one of claims 1 to 4, wherein
   the material is a ceramic, a glass ceramic, a polymer material, a composite resin, a glass ionomer, or a metal.

6. The method according to any one of claims 1 to 4, wherein
   the property value is biaxial flexural strength.

7. A program causing a computer to execute procedures of:

   acquiring a property value of a material;
   predicting a feature of the material based on the acquired property value of the material by performing an inverse analysis on a model that predicts a property value of the material based on a feature of the material; generating a result of topological data analysis based on the predicted feature of the material; and presenting, on an image of a material different from the material, a pixel corresponding to a portion designated in the result of the topological data analysis.

8. A device, comprising:

   an acquisition unit configured to acquire a property value of a material;
   a prediction unit configured to predict a feature of the material based on the acquired property value of the material by performing an inverse analysis on a model that predicts a property value of the material based on a feature of the material;
   a topological data analysis unit configured to generate a result of topological data analysis based on the predicted feature of the material; and
   a presentation unit configured to present, on an image of a material different from the material, a pixel corresponding to a portion designated in the result of the topological data analysis.

# FIG.1

# FIG.2

# FIG.3

LEARNING DEVICE ⟋20

| 201 | 202 | 203 |
|---|---|---|
| TRAINING DATA ACQUISITION UNIT | FEATURE EXTRACTION UNIT | LEARNING UNIT |

| 204 | 205 |
|---|---|
| FEATURE VISUALIZATION UNIT | OPTIMIZATION UNIT |

# FIG.4

INVERSE ANALYSIS (CONDITION PREDICTION) DEVICE ⟋30

| 301 | 302 |
|---|---|
| PROPERTY VALUE ACQUISITION UNIT | PREDICTION UNIT |

| 303 | 304 |
|---|---|
| TOPOLOGICAL DATA ANALYSIS UNIT | PRESENTATION UNIT |

# FIG.5

START

S11

ACQUIRE IMAGE OF MATERIAL

S12

DIVIDE IMAGE

S13

PERFORM TOPOLOGICAL DATA ANALYSIS ON IMAGE(S) OF MATERIAL TO EXTRACT FEATURES OF MATERIAL

S14

PERFORM DIMENSIONALITY REDUCTION ON FEATURES OF MATERIAL

S15

PREDICT PROPERTY VALUE OF MATERIAL FROM FEATURES OF MATERIAL

S16

PRESENT RESULTS OF PREDICTION

END

# FIG.6

START

S21
ACQUIRE IMAGES OF MATERIALS AND ACTUAL
MEASUREMENT VALUES OF PROPERTIES OF MATERIALS

S22
DIVIDE IMAGES

S23
DETERMINE PARAMETERS

S24
PERFORM TOPOLOGICAL DATA ANALYSIS ON IMAGES
TO EXTRACT FEATURES OF MATERIALS

S25
PERFORM DIMENSIONALITY REDUCTION
ON FEATURES OF MATERIALS

S26
VISUALIZE FEATURES OF MATERIALS

S27
PERFORM MACHINE LEARNING TO
GENERATE TRAINED MODEL

END

# FIG.7

START

S31

ACQUIRE PROPERTY VALUE OF MATERIAL

S32

PERFORM INVERSE ANALYSIS ON MODEL FOR PREDICTING
PROPERTY VALUE OF MATERIAL FROM FEATURES
OF MATERIAL AND PREDICT FEATURE OF MATERIAL
FROM PROPERTY VALUE OF MATERIAL

S33

CONDUCT INVERSE TRANSFORM
OF DIMENSIONALITY REDUCTION

S34

GENERATE RESULTS OF TOPOLOGICAL DATA ANALYSIS

S35

PRESENT, ON IMAGE OF DIFFERENT MATERIAL,
PIXEL CORRESPONDING TO PORTION DESIGNATED
IN RESULTS OF TOPOLOGICAL DATA ANALYSIS

END

FIG.8

<FORWARD ANALYSIS>

IMAGE OF MATERIAL

↓ S101

PERSISTENT HOMOLOGY
(IMAGE OF MATERIAL
→ PERSISTENCE DIAGRAMS)

↓ S102

VECTORIZATION
(PERSISTENCE DIAGRAMS
→ VECTORS)

↓ S103

PRINCIPAL COMPONENT ANALYSIS
(VECTORS
→ PRINCIPAL COMPONENTS)

↓ S104

REGRESSION ANALYSIS
(PRINCIPAL COMPONENTS →
PROPERTY VALUE OF MATERIAL)

↓

PROPERTY VALUE
OF MATERIAL

BAYESIAN
OPTIMIZATION

<INVERSE ANALYSIS>

IMAGE

↑ S114

PRESENT, ON IMAGE OF DIFFERENT
MATERIAL, PIXEL CORRESPONDING
TO PORTION DESIGNATED
IN PERSISTENCE DIAGRAM

↑ S113

INVERSE TRANSFORM
OF VECTORIZATION
(VECTORS
→ PERSISTENCE DIAGRAMS)

↑ S112

INVERSE TRANSFORM OF
PRINCIPAL COMPONENT ANALYSIS
(PRINCIPAL COMPONENTS
→ VECTORS)

↑ S111

INVERSE ANALYSIS
OF REGRESSION MODEL
(PROPERTY VALUE OF MATERIAL
→ PRINCIPAL COMPONENTS)

↑

PROPERTY VALUE
OF MATERIAL

EP 4 693 176 A1

# FIG.9

<BEFORE DIVISION>

<AFTER DIVISION>

EP 4 693 176 A1

# FIG.10

<IMAGE>

GRAYSCALE IMAGE

BINARIZED IMAGE

POINT CLOUD DATA
OF CRYSTAL GRAIN
CENTROIDS

# FIG.11

⟨PERSISTENCE DIAGRAMS⟩

# FIG.12

# FIG.13

# FIG.14

# FIG.15

# FIG.16

CLUSTER IN REGION
DISTANT FROM OTHERS

FIG.17

FIG.18

EP 4 693 176 A1

FIG.19

[PERSISTENCE DIAGRAM GENERATED BY INVERSE TRANSFORM]

[PERSISTENCE DIAGRAM OF DIFFERENT MATERIAL]

[IMAGE OF DIFFERENT MATERIAL]

PIXEL CORRESPONDING TO PORTION DESIGNATED IN PERSISTENCE DIAGRAM

PORTION CORRESPONDING TO PORTION DESIGNATED IN PERSISTENCE DIAGRAM

PORTION DESIGNATED IN PERSISTENCE DIAGRAM

# FIG.20

CPU 1001

ROM 1002

RAM 1003

AUXILIARY STORAGE DEVICE 1004

B

DISPLAY DEVICE 1005

OPERATING DEVICE 1006

INTERFACE DEVICE 1007

DRIVE DEVICE 1008

10,20,30

NETWORK

STORAGE MEDIUM 1009

## INTERNATIONAL SEARCH REPORT

| International application No. |
| --- |
| **PCT/JP2024/011403** |

| A. | CLASSIFICATION OF SUBJECT MATTER |
| --- | --- |

*G06T 7/00*(2017.01)i; *G01N 3/20*(2006.01)i
FI: G06T7/00 350B; G01N3/20

According to International Patent Classification (IPC) or to both national classification and IPC

| B. | FIELDS SEARCHED |
| --- | --- |

Minimum documentation searched (classification system followed by classification symbols)

G06T7/00; G01N3/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | 平岡裕章ほか2名, マテリアルズ インフォマティクス パーシステント ホモロジーと材料構造解析, 人工知能 vol. 34, no. 3, Journal of the Japanese Society for Artificial Intelligence. 01 May 2019, pp. 330-338, (HIRAOKA, Yasuaki et al. Persistent Homology and Structural Analysis in Materials Science.)<br>5. Structural analysis of silica glasses, 7. Machine learning for persistence diagrams, fig. 8 | 1-8 |
| A | 小嗣 真人, 山田 拓洋, 鈴木 真悟, 鈴木 雄太, 大林 一平, 平岡 裕章, トポロジカル機械学習を用いた保磁力支配因子の可視化, 2018年 第65回応用物理学会春季学術講演会 [講演予稿集] The 65th JSAP Spring Meeting, 2018 [Extended Abstracts]. 公益社団法人応用物理学会 The Japan Society of Applied Physics. 2018, p. 10, (KOTSUGI, Masato. YAMADA, Takumi. SUZUKI, shingo. SUZUKI, Yuta. OBAYASHI, Ippei. HIRAOKA, Yasuaki. Feature extraction of coercivity using topological machine learning.)<br>entire text, all drawings | 1-8 |

☐ Further documents are listed in the continuation of Box C.　　☐ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
| --- | --- |
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **31 May 2024** | **11 June 2024** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7188644 B
- JP 2023050102 A